# EUROPEAN PATENT SPECIFICATION

(11) **EP 3 383 057 B1**
(45) Date of publication and mention of the grant of the patent: **03.05.2023**
(21) Application number: 18163336.3
(22) Date of filing: 22.03.2018
(51) Int. Cl.: H04Q 9/00

(54) **MODULAR METERING DEVICE AND METHOD FOR OPERATING SAME**
MODULARE DOSIERUNGSVORRICHTUNG UND VERFAHREN ZUM BETRIEB DAVON
DISPOSITIF DE MESURE MODULAIRE ET SON PROCÉDÉ DE FONCTIONNEMENT

(30) Priority: 27.03.2017 CH 3992017
(43) Date of publication of application: 03.10.2018
(73) Proprietor: Landis+Gyr AG, 6330 Cham (CH)
(72) Inventor: Maaranen, Jani, Peterborough, PE6 9QQ (GB); Kaipainen, Pasi, 40630 Jyväskylä (FI); Haas, Jürg, 6343 Rotkreuz (CH)
(74) Representative: Marks & Clerk LLP

(56) References cited:
- EP-A1- 2 469 494
- EP-A2- 2 456 227
- US-B1- 9 001 787

## Description

The present disclosure relates to a metering device, in particular electricity meter for metering electrical energy in an Advanced Metering Infrastructure (AMI) System, comprising a communication unit enabling node mesh communication between the metering device and at least one further metering device.

Furthermore, the present disclosure relates to an AMI system for metering utility consumption.

Moreover, the present invention relates to a communication module comprising a meter interface for connecting the communication module to a metering device for metering electrical energy in an AMI System.

Finally, the present invention relates to a method for operating an AMI system comprising metering devices configured for mesh node communication with each other.

### BACKGROUND

AMI systems are commonly used for measuring, collecting and analysing utility consumption data, for example the consumption of electrical energy, gas, heat, water, etc. The measurements are conducted with the help of metering devices located at the premises of utility consumers, such as households, businesses, industries or alike. The metering devices communicate with each other in order to electronically exchange measurement data and other information in that they are configured and arranged as a communication mesh network, wherein each metering device acts as a node within the mesh network.

Certain numbers of metering devices, for example metering devices installed in a block of flats which establish a mesh network with each other, constitute a metering cluster. Within the cluster, the metering devices commonly are connected to each other via Radio Frequency signals (RF) and/or Power Line Communication (PLC). In addition to the metering devices, a Data Concentrator (DC) is installed which acts as a gateway establishing an uplink and/or downlink within the AMI system and that the DC gathers measurement data from the metering devices within the cluster and forwards the data in an aggregated state via an uplink towards a Head End System (HES) of the AMI.

The HES receives and collects metering data from a plurality of DCs. The DCs communicate with the HES typically via Ethernet or Cellular IP-based technologies or as an alternative via RF and/or PLC, in particular G3 PLC. Within the HES, the metering data can be verified and prepared for analysis. The HES commonly forwards the so consolidated metering data to a clearing system for billing of the consumption. Moreover, the metering data and values from analyses thereof can be used for controlling energy consumption. US 9 001 787 B1, for example, describes a system and process for switching to or between multiple networks to optimize communication between an energy device, e.g., meter, in proximity to at least one of the multiple networks and a head end server to facilitate communication of energy-related data therebetween. The system includes a communications module associated with the energy device for controlling the switching between networks and/or the directing of energy-related data communications over different networks in accordance with data type.

A disadvantage arising from AMI Systems according to the prior art is that once the metering devices and the DC are installed, a proper functionality of their specific arrangement in terms of communication amongst each other is only assured for the conditions under which the respective RF and/or PLC communication paths have been established upon installation. Should afterwards any interruptions or obstacles occur in the established paths, the communication may be impaired or cut-off between the metering devices amongst each other, between the metering devices and the DC and/or between the DC and the HES. Such interruptions or obstacles may occur when for instance constructions within the premises where the metering devices are installed are changed, e.g. by building additional structures, such as buildings, walls, ceilings, or by altering powerlines.

In order to then re-establish a proper communication between metering devices, DC and the HES, additional communication means and paths have to be installed. These additional communication means and paths may comprise e.g. more metering devices, RF repeaters, further powerlines, DCs and alike. Their installation can be cumbersome and costly. Furthermore, data integrity may be at risk when the interruptions or obstacles are not noted fast enough in order to take countermeasures in a timely manner.

### SUMMARY

It is an objective of the present invention to remedy at least some of the disadvantages of AMI Systems according to the prior art described above.

The object of the invention is solved by the features of the independent claims. Further embodiments are the subject-matter of the dependent claims.

A metering device comprises a module interface configured to connect a communication module to the metering device for enabling the metering device to establish an uplink and/or downlink connection within an AMI system. The communication module comprises a gateway unit configured to communicate within an AMI system metering data received via the meter interface. By adding a communication module to a metering device, the metering device is transformed from being merely a communication mesh node configured for communication with at least one further metering device acting as a mesh node, into a gateway configured to establish an uplink and/or downlink connection within the AMI system for at least one cluster constituted by the metering device and at least one further metering device configured for mesh node communication with each other.

This solution has the advantage over the prior art that an AMI is adaptable to changing environmental conditions through adding a communication module to a metering device. The metering device then becomes a gateway and is able to transmit measurement data to a gateway, such as a DC or even become the gateway or the DC. Thereby, with a metering device according to the present invention, any interruptions or obstacles in communication paths occurring in the planning or installation phase of the AMI or after it has been installed and set into operation can be easily circumvented. This renders an AMI system according to the present invention very flexible and adaptable to changing environmental conditions.

Thereby, metering device, AMI system, and method according to the present invention help to increase planning certainty in the design and configuration of AMIs. The increased flexibility and adaptability of metering devices, AMI systems, and methods according to the present invention in comparison to the prior art helps to lower costs and efforts, both on the manufacturing side as well as on the installation and configuration side. The gained flexibility and adaptability facilitates to make planning, management and purchasing decisions, since AMIs according to the present invention may be easily changed any time.

The inventive solution may be combined and improved by the following further embodiments, which are each advantageous on their own.

In a first further embodiment, the communication unit enables the metering device to serve as at least one of an RF and a PLC mesh node. Thereby, RF and/or PLC mesh node communication can be implemented as standard options within metering devices according to the present invention. This helps, to further facilitate manufacturing, design, installation and configuration of the metering devices themselves as well as AMI Systems containing them, thus enabling to reduce costs of the systems as well as efforts in adapting them.

In some embodiments, the metering device comprises on board communication extensions including at least one of a wireless M-Bus and a wired M-Bus. Such bus-systems allow for connecting additional metering devices to the metering device. For instance, when the metering device is an electricity meter, the additional metering devices may be gas meters, heat meters, water meters or alike, which may be connected to a metering device according to the present invention via the M-Bus. The metering device may retrieve data from such additional metering devices in order to forward and/or compute that data.

In some embodiments, the metering device comprises a Home Area Network (HAN) interface for at least one of a serial port, a Dutch Smart Meter Requirements (DSMR) port, and an auxiliary I/O port for controlling load control relays and inputs. Through the serial port, e.g. RS-485, the meter may be configured and/or the meter may control other appliances. Through the DSMR port, metering device according to the present invention may communicate according to the respective DSMR standard. Auxiliary I/O ports enable a metering device according to the present invention to switch appliances on or off. Appliances to be controlled or switched may comprise any household or industrial appliances consuming a certain type of utility measured by the metering device itself or by additional metering devices connected thereto.

In some embodiments, the metering device comprises a supply control switch. With the supply control switch, the metering device can switch off at least part of a utility supply metered. Thereby, insecure or an unauthorised provision of that utility may be prevented via remote control by an operator through the metering device or by the metering device itself upon automatic reactions to certain thresholds or switching conditions stored in the metering device.

In a preferred embodiment, the metering device comprises a module slot within an enclosure of the metering device containing the module interface, and is adapted to at least partly accommodate the communication module. For installing the communication module within the metering device, the communication module may be inserted into the module slot. After insertion, the communication module is received in the slot and thereby at least partly accommodated within the enclosure which helps to protect the communication module against harmful environmental impacts. Furthermore, the module slot may be designed such that the communication module may be completely accommodated within the enclosure. Therefore, the slot may be closed by a lid.

In a preferred embodiment, the communication module enables the metering device to serve as at least one of an RF mesh gateway and a PLC gateway within the AMI system. As a PLC Gateway or mesh node , the metering device may function according to the G3 standard, for example. Hence, any mesh node metering device may easily become such a gateway by adding a communication module of the AMI system according to the present invention to the metering device. For example, the built in RF of G3 node functionality of the metering device is used by the communication module. Hence, the operation of the metering device changes from node to a gateway.

In some embodiments, the communication module enables the metering device to serve as a peer or communication point for establishing a peer-to-peer and/or point-to-point (P2P) connection within the AMI system. As a peer or communication point, the metering device may directly communicate with other devices within the HES, for example with a gateway. Any gateway functions of the metering device according to the present invention may involve wired or wireless communication standards, such as the Long-Term Evolution (LTE) standard.

In a preferred embodiment, as the RF mesh gateway, the PLC gateway, and/or the peer, the metering device is configured to establish an uplink connection towards an HES of the AMI system. Thereby, a metering device according to the present invention can pass on metering data acquired by itself or as received from other metering devices to the HES. In doing so, metering device according to the present invention may even function as a gateway or DC. Hence, the present invention enables to transform a node mesh communication metering device into a DC simply by adding a communication module of the AMI system according to the present invention to the metering device.

For a communication module of the AMI system according to the present invention, the solution of to the objective as outlined above may further be improved in that the communication module comprises a memory unit containing computer readable instructions for implementing additional firmware in the metering device, and in that the additional firmware enables the metering device to serve as the gateway. Upon installation of the communication module in the metering device, the additional firmware may be provided in order to be installed on the metering device via the module interface. Therefore, the additional firmware may be either already stored within the memory unit when the communication module is added to the metering device, or at least a part of the firmware may be downloaded through the AMI onto the metering device through the communication module. This helps in easily enabling a metering device according to the present invention to become a gateway and to be configured as such.

For example, a communication module configured for P2P-communication transforms a Point-to-Multipoint (P2M) metering point from a node mesh network, such as a RF or G3 neighbourhood area network (NAN) to a cellular P2P communication device. Alternatively or additionally, a gateway may retain a P2M nature of the communication and at the same time may provide access to other devices in the AMI as a gateway or with DC logic towards upper level AMI components, typically an HES.

In a method according to the present invention, the solution to the objective as outlined above may be further improved in that as at least one step of the transformation, the communication module is being inserted into the metering device. Upon insertion of the communication module to the metering device, the meter interface can be automatically connected to the module interface, thereby establishing in electrical connection between the metering device and the communication module for exchanging data and electrical power therebetween. This facilitates installing the communication module at the metering device.

In a preferred embodiment, in the course of the transformation, at least one of additional firmware and configuration data enabling the metering device to serve as the gateway is provided to the metering device through the communication module. As already outlined above, such a provision of additional firmware and configuration data facilitates a transformation of a metering device acting as a mesh node, into a gateway. Installation of the additional firmware and configuration data within the metering device may be automated as desired. Thereby, a number of manual installation and operation steps to be performed for the transformation maybe minimised.

### BRIEF DESCRIPTION OF THE DRAWINGS

In order to describe the manner in which advantages and features of the disclosure can be obtained, in the following a more particular description of the principles briefly described above will be rendered by reference to specific embodiments thereof which are illustrated in the appended drawings. These drawings depict only exemplary embodiments of the present disclosure and are not therefore to be considered to be limiting of its scope.

In the drawings:
- Fig. 1: shows a schematic perspective view of a metering device according to an embodiment of the present invention;
- Fig. 2: shows a schematic perspective view of the metering device illustrated in fig. 1 with a lid of an enclosure of the metering device opened in order to enable access to a communication module of the AMI system according to an embodiment of the present invention.
- Fig. 3: shows a schematic perspective view of the metering device illustrated in figs.1 and 2 with the communication module being ready to be inserted into a module slot of the metering device;
- Fig. 4: shows a schematic illustration of an AMI system according to an embodiment of the present invention;
- Fig. 5: shows a schematic perspective partly cross-sectioned view of a metering device connected to a communication module according to an embodiment of the present invention; and
- Fig. 6: shows a schematic perspective view of a metering device connected to a communication module according to an embodiment of the present invention.

### DESCRIPTION

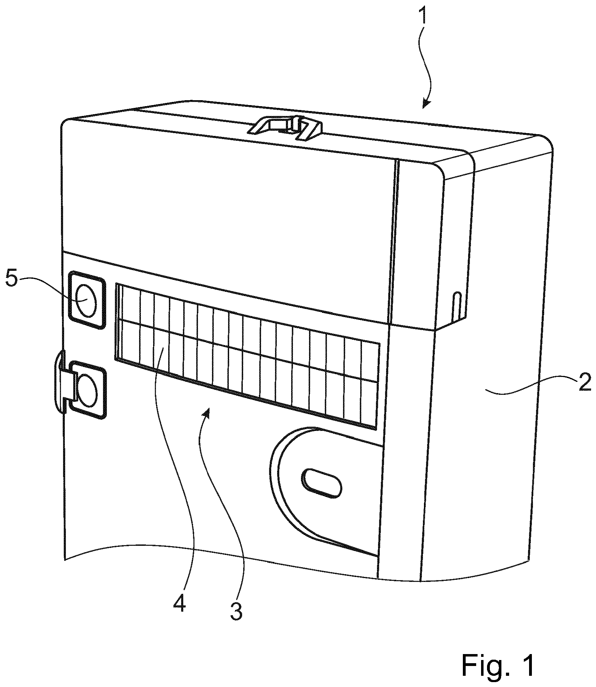

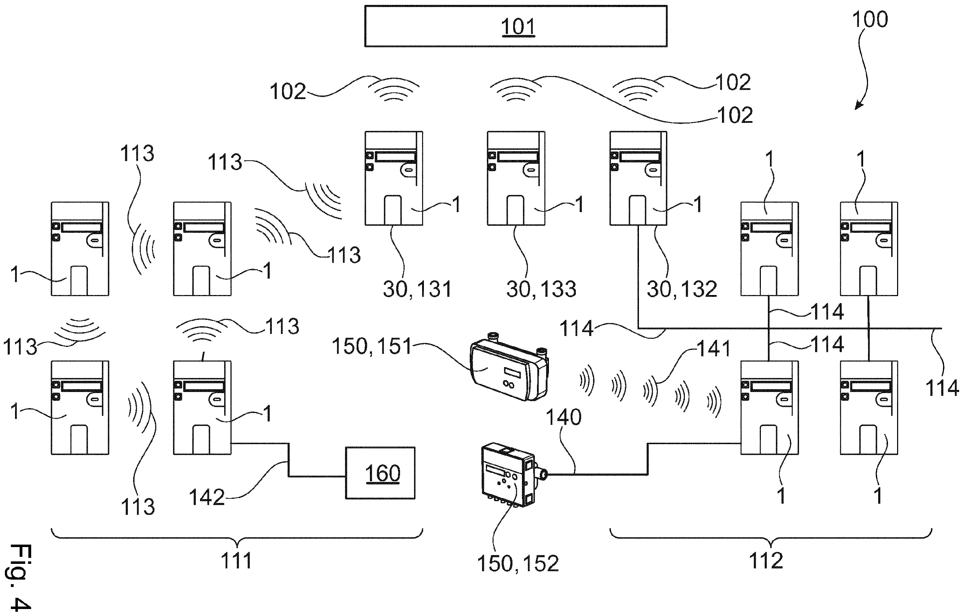

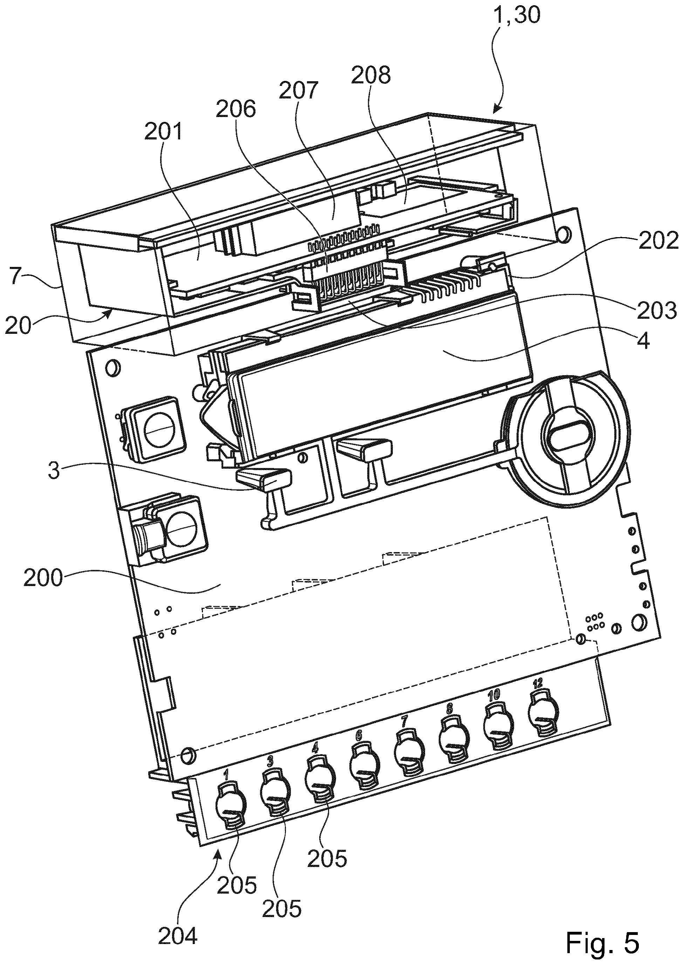

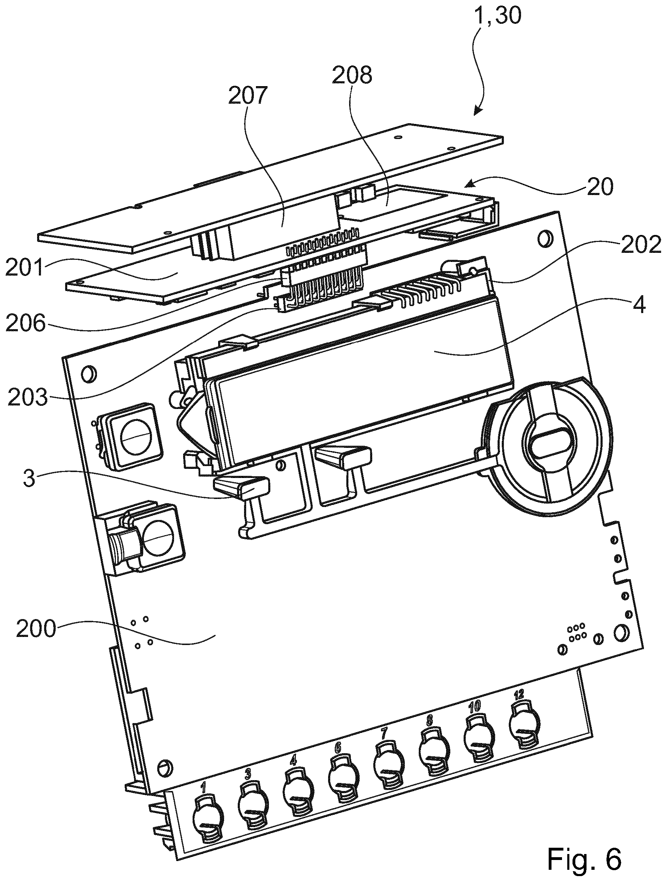

Fig. 1 shows a schematic perspective view of a metering device 1 according to an embodiment of the present invention. The metering device 1 has an enclosure 2 providing a front panel 3. At the front panel 3, a display 4 and controls 5 are arranged for operating the metering device 1. The metering device 1 further comprises a communication unit (see Figs. 5 and 6) enabling node mesh communication between the metering device 1 and at least one further metering device 1 (see Fig. 4).

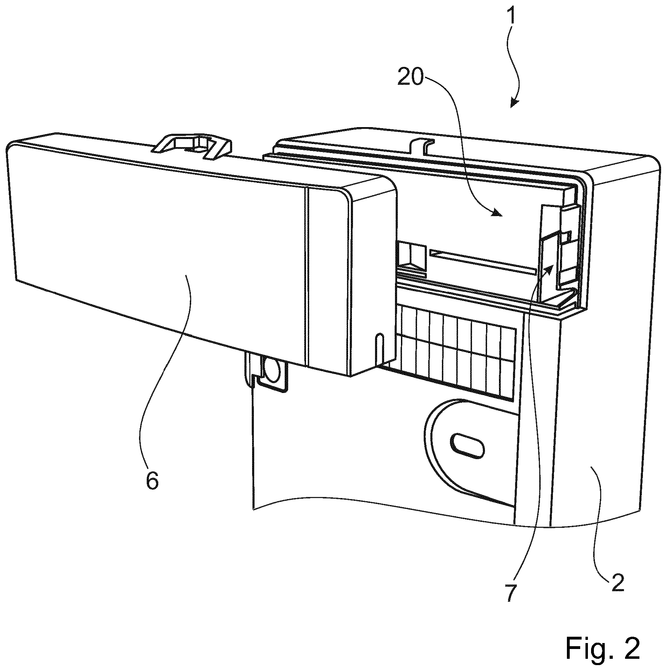

Fig. 2 shows a schematic perspective view of the metering device 1 with a lid 6 of the enclosure 2 of the metering device 1 opened, so that a module slot 7 of the metering device 1 closable by the lid 6 is accessible. Within the module slot 7, a module interface (see Figs. 5 and 6) is arranged and a communication module 20 is accommodated. The communication module 20 has a meter interface (see Figs. 5 and 6) connected to the module interface of the metering device 1.

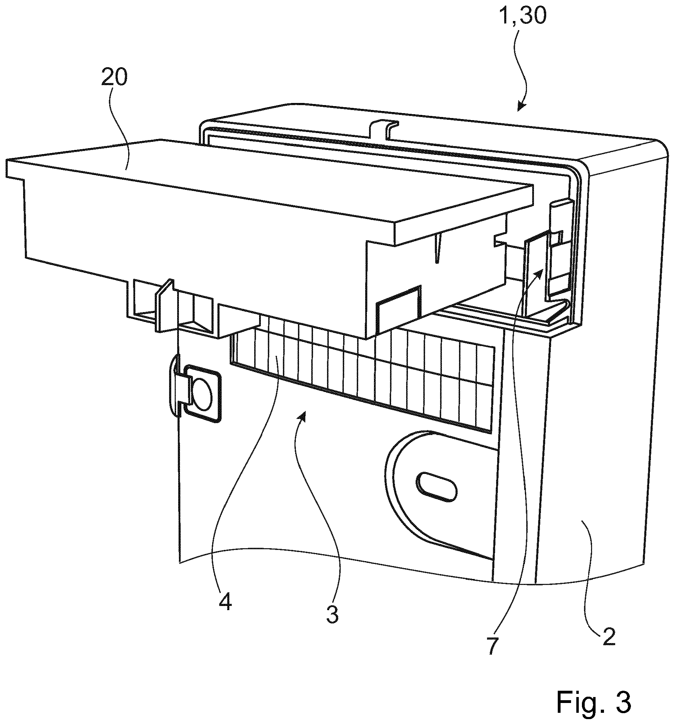

Fig. 3 shows a schematic perspective view of the metering device 1 with the communication module 20 being separated from the metering device 1. The communication module 20 is ready to be inserted into a module slot 7 of the metering device 1. By inserting the communication module 20 into the module slot 7, the meter interface is automatically connected to the module interface.

The communication module 20 comprises a memory unit (not shown) containing additional firmware and/or configuration data enabling the communication unit of the metering device 1 to interact with the communication module 20. Alternatively, or additionally, the metering device 1 can retrieve additional firmware and/or configuration data via the communication module 20 and that such additional firmware and/or configuration data is downloaded from a remote location onto the metering device 1 via the communication module 20. Once the communication module 20 is properly installed and operative, the metering device 1 is provided with additional functional and communicational capacities. Thereby, the metering device 1 becomes a gateway 30 (see Fig. 4).

Fig. 4 shows a schematic illustration of an AMI system 100 according to an embodiment of the present invention. The AMI system 100 comprises a number of metering devices 1 of which some additionally function as a gateway 30 in order to communicate with an HES 101 of the AMI system 100 via an uplink 102. The metering devices 1 are arranged in to clusters, namely an RF cluster 111 and a PLC cluster 112. Within the RF cluster 111, the metering devices 1 communicate with each other via RF signals 113. Within the pic cluster 111, 112, the metering devices 1 communicate with each other via power line 114 as enabled through their respective internal communication units.

At least one of the metering devices 1 of every cluster 111, 112 is provided with the communication module 20 and thereby enabled to establish the uplink connection 102 to the HES 101. For the RF cluster 111, the respective metering device 1 functioning as the gateway 30 is configured as an RF mesh gateway 131. For the pic cluster 1 12, the respective metering device 1 functioning as the gateway 30 is configured as a PLC gateway 132. Furthermore, at least 1 of the metering devices 1 installed as a stand-alone meter is configured as a peer 133 and as such communicates with the HES 101 in a P2P connection. The respective uplinks 102 are made by means of the desired communication standards, e.g. LTE, GPRS, CDMA.

In addition, the metering devices 1 can comprise preferably on board communication extensions including at least one of a wireless M-Bus 140 and a wired M-Bus 141. Further, the metering devices 1 may comprise and a HAN interface 141 for at least one of a serial port, a DSMR port, and an auxiliary I/O port for controlling load control relays and inputs. Moreover, the metering devices may comprise a supply control switch (not shown) for switching a respective utility supply.

By means of the wireless M-Bus 140 and the wired M-Bus 141, the respective metering device 1 can be bi-directionally connected to an additional metering device 150, such as a gas meter 151, a heat meter 152 or alike. Through the respective connection, the metering device 1 can retrieve metering data from the additional metering device 150 as well as configure the additional metering device 150. The HAN interface 141 allows for operating appliances 160, such as household or industrial appliances, for example, by means of the respective metering device 1."

Fig 5 shows a schematic perspective partly cross-sectioned view of the metering device 1 connected to the communication module 20 according to an embodiment of the present invention. The communication module 20 is accommodated within the module slot 7 of the metering device 1. The metering device 1 and the communication module 20 each comprise electronic circuits which are provided on printed circuit boards (PCB), respectively. The metering device 1 comprises a metering PCB 200. The communication module 20 comprises module PCB 201.

The metering PCB 200 carries the display 4 and parts of the front panel 3. Furthermore, the metering PCB 200 carries a meter communication unit 202 of the metering device 1 configured for establishing node mesh communication within the AMI system 100. A module interface 203 of the metering device 1 is provided on the metering PCB 200 for connecting the communication module 20 to the metering device 1. Moreover, a terminal section 204 of the metering device 1 is connected to the metering PCB 200 in order to be able to connect electrical power supply lines (not shown) to the metering device 1. The terminal section 204 comprises terminals 205, each configured for connecting an electrical line (not shown) to the metering device1.

The module PCB 201 carries a module communication unit 207 configured for enabling the metering device 1 to establish at least one of the uplink and/or downlink connections 102 within the AMI system 100. A meter interface 206 is provided on the module PCB 201 for connecting the metering device 1 to the communication module 20. Furthermore, the module PCB 201 carries a module memory unit 208 of the module 20.

Fig. 6 shows a schematic perspective view of the metering device 1 connected to the communication module 20 according to an embodiment of the present invention. Connecting the communication module 20 the metering device 1 allows the metering device 1 to serve as a gateway 30 in an AMI system 100. By connecting the communication module 20 to the metering device 1, the metering device 1 can access the module communication unit 207 and the module memory unit 208 over the meter interface 206 and the module interface 203.

Any software or other firmware can be downloaded by the metering device 1 through the AMI system 100 by using the module communication unit 207 and/or the module memory unit 208.

Deviations from the above-described embodiments are possible within the scope of the present invention as claimed.

### Reference Numerals

- 1: Metering device
- 2: enclosure
- 3: front panel
- 4: display
- 5: controls
- 6: lid
- 7: module slot
- 20: communication module
- 30: Gateway
- 100: AMI System
- 101: HES
- 102: Uplink/Downlink
- 111: RF cluster
- 112: PLC cluster
- 113: RF signals
- 114: Powerline
- 131: RF mesh gateway
- 132: PLC Gateway
- 133: Peer or communication point
- 140: wireless M-Bus 140
- 141: wired M-Bus 141
- 142: HAN interface
- 150: additional metering device
- 151: gas meter
- 152: heat meter
- 160: appliance
- 200: Metering PCB
- 201: Module PCB
- 202: Meter communication unit
- 203: Module interface
- 204: Terminal section
- 205: Terminals
- 206: Meter interface
- 207: Module communication unit
- 208: Module memory unit

## Claims

1. Metering device (1), in particular electricity meter for metering electrical energy in an Advanced Metering Infrastructure AMI System (100), comprising a communication unit (202) enabling node mesh communication between the metering device (1) and at least one further metering device (1),
**characterised in that**
the metering device (1) comprises a module interface (203) configured to connect a communication module (20) to the metering device (1) for enabling the metering device to establish an uplink and/or downlink connection (102) within the AMI system (100), and passing on metering data acquired by itself or as received from the at least one further metering device (1) towards a Head End System HES (101) of the AMI System (100) so that by adding the communication module (20) to the metering device (1), the metering device (1) is transformed from being merely a communication mesh node configured for communication with the at least one further metering device (1) acting as a mesh node, into a gateway (30) configured to establish the uplink and/or downlink (102) connection within the AMI system (101) for at least one cluster (111, 112) constituted by the metering device (1) and the at least one further metering device (1) configured for mesh node communication with each other.

2. Metering device (1) according to claim 1, **characterised in that** the metering device (1) is configured to communicate with the at least one further metering device (1) via Radio Frequency signals RF and/or Power Line Communication PLC.

3. Metering device (1) according to claim 1 or 2, **characterised in that** the metering device (1) comprises on board communication extensions including at least one of a wireless M-Bus (140) and a wired M-Bus (141).

4. Metering device (1) according to at least one of claims 1 to 3, **characterised in that** the metering device (1) comprises a Home Area Network HAN interface (142) for at least one of a serial port, a Dutch Smart Meter Requirements DSMR port, and an auxiliary I/O port for controlling load control relays and inputs.

5. Metering device (1) according to at least one of claims 1 to 4, **characterised in that** the metering device (1) comprises a supply control switch.

6. Metering device (1) according to at least one of claims 1 to 5, **characterised in that** a module slot (7) within an enclosure (2) of the metering device (1) contains the module interface and is adapted to at least partly accommodate the communication module (20).

7. Advanced Metering Infrastructure AMI System (100) for metering utility consumption, in particular of electrical energy **characterised by** a metering device (1) according to at least one of claims 1 to 6 above, and a communication module (20) comprising a meter interface (206) for connecting the communication module (20) to the metering device (1) and a gateway unit configured to communicate within the AMI System (100) metering data received via the meter interface (206).

8. AMI System (100) according to claim 7, **characterised in that** the communication module (20) enables the metering device (1) to serve as at least one of an RF Mesh Gateway (131) and a PLC Gateway (132) within the AMI system (100).

9. AMI System (100) according to at least one of claims 7 to 8, **characterised in that** the communication module enables the metering device (1) to serve as a peer (133) for establishing a P2P connection within the AMI system (100).

10. AMI System (100) according to claim 8 or 9, **characterised in that** as the RF Mesh Gateway (131), the PLC Gateway (132), and/or the peer (133), the metering device (1) is configured to establish the uplink connection (102) towards an HES (101) of the AMI system (100).

11. Method for operating an Advanced Metering Infrastructure AMI System (100) comprising metering devices (1) according to any of claims 1 to 6 configured for mesh node communication with each other, **characterised in that** by adding a communication module (20) to a metering device (1), the communication module (20) comprising a meter interface (206) for connecting the communication module (20) to any of the metering devices (1) and a gateway unit configured to communicate with the AMI System (100) metering data received via the meter interface (206), the respective metering device (1) is transformed from being merely a communication mesh node configured for communication with at least one further metering device (1) acting as a mesh node, into a gateway (30) configured to establish an uplink and/or downlink (102) connection within the AMI system (101) for at least one cluster (111, 112) constituted by the respective metering device (1) and at least one further metering device (1) configured for mesh node communication with each other.

12. Method according to claim 11, **characterised in that** as at least one step of the transformation, the communication module (20) is being inserted into the metering device (1).

13. Method according to claim 11 or 12, **characterised in that** in the course of the transformation, at least one of additional firmware and configuration data enabling the metering device (1) to serve as the gateway (30) is provided to the metering device (1) through the communication module (20).

## Patentansprüche

1. Messvorrichtung (1), insbesondere Elektrizitätszähler zum Messen von elektrischer Energie in einem Advanced Metering Infrastructure(AMI)-System (100), umfassend eine Kommunikationseinheit (202), die eine Knoten-Mesh-Kommunikation zwischen der Messvorrichtung (1) und mindestens einer weiteren Messvorrichtung (1) ermöglicht,
**dadurch gekennzeichnet, dass**
die Messvorrichtung (1) eine Modulschnittstelle (203) umfasst, die so konfiguriert ist, dass sie ein Kommunikationsmodul (20) mit der Messvorrichtung (1) verbindet, um die Messvorrichtung in die Lage zu versetzen, eine Uplink- und/oder Downlink-Verbindung (102) innerhalb des AMI-Systems (100) aufzubauen, und von ihr selbst erlangte oder von der mindestens einen weiteren Messvorrichtung (1) empfangene Messdaten an ein Head-End-System (HES) (101) des AMI-Systems (100) weiterzuleiten, sodass durch Hinzufügen des Kommunikationsmoduls (20) zur Messvorrichtung (1) die Messvorrichtung (1) von einem einfachen Kommunikations-Mesh-Knoten, der für eine Kommunikation mit der mindestens einen weiteren Messvorrichtung (1), die als ein Mesh-Knoten fungiert, konfiguriert ist, in ein Gateway (30) umgewandelt wird, das konfiguriert ist, um die Uplink- und/oder Downlink-Verbindung (102) innerhalb des AMI-Systems (101) für mindestens einen Cluster (111, 112) aufzubauen, der aus der Messvorrichtung (1) und der mindestens einen weiteren Messvorrichtung (1) besteht, die für eine Mesh-Knoten-Kommunikation miteinander konfiguriert sind.

2. Messvorrichtung (1) nach Anspruch 1, **dadurch gekennzeichnet, dass** die Messvorrichtung (1) so konfiguriert ist, dass sie mit der mindestens einen weiteren Messvorrichtung (1) über Hochfrequenzsignale (RF) und/oder Stromleitungskommunikation (PLC) kommuniziert.

3. Messvorrichtung (1) nach Anspruch 1 oder 2, **dadurch gekennzeichnet, dass** die Messvorrichtung (1) bordeigene Kommunikationserweiterungen umfasst, die mindestens einen von einem drahtlosen M-Bus (140) oder einem verdrahteten M-Bus (141) einschließen.

4. Messvorrichtung (1) nach mindestens einem der Ansprüche 1 bis 3, **dadurch gekennzeichnet, dass** die Messvorrichtung (1) eine Heimnetzwerk(HAN)-Schnittstelle (142) für mindestens einen von einem seriellen Anschluss, einem Dutch Smart Meter-Requirements(DSMR)-Anschluss und einem zusätzlichen E/A-Anschluss zum Steuern von Laststeuerrelais und -eingängen umfasst.

5. Messvorrichtung (1) nach mindestens einem der Ansprüche 1 bis 4, **dadurch gekennzeichnet, dass** die Messvorrichtung (1) einen Versorgungssteuerschalter umfasst.

6. Messvorrichtung (1) nach mindestens einem der Ansprüche 1 bis 5, **dadurch gekennzeichnet, dass** ein Modulsteckplatz (7) innerhalb eines Gehäuses (2) der Messvorrichtung (1) die Modulschnittstelle enthält und geeignet ist, das Kommunikationsmodul (20) mindestens teilweise aufzunehmen.

7. Advanced Metering Infrastructure(AMI)-System (100) zum Messen eines Verbrauchs von Energie, insbesondere von elektrischer Energie,
**gekennzeichnet durch** eine Messvorrichtung (1) nach mindestens einem der obigen Ansprüche 1 bis 6, und ein Kommunikationsmodul (20), das eine Zählerschnittstelle (206) zum Verbinden des Kommunikationsmoduls (20) mit der Messvorrichtung (1) und eine Gateway-Einheit umfasst, die so konfiguriert ist, dass sie innerhalb des AMI-Systems (100) Messdaten kommuniziert, die über die Zählerschnittstelle (206) empfangen werden.

8. AMI-System (100) nach Anspruch 7, **dadurch gekennzeichnet, dass** das Kommunikationsmodul (20) die Messvorrichtung (1) in die Lage versetzt, innerhalb des AMI-Systems (100) als mindestens eines von einem RF-Mesh-Gateway (131) und einem PLC-Gateway (132) zu dienen.

9. AMI-System (100) nach mindestens einem der Ansprüche 7 bis 8, **dadurch gekennzeichnet, dass** das Kommunikationsmodul die Messvorrichtung (1) in die Lage versetzt, als ein Peer (133) zum Aufbau einer P2P-Verbindung innerhalb des AMI-Systems (100) zu dienen.

10. AMI-System (100) nach Anspruch 8 oder 9, **dadurch gekennzeichnet, dass** die Messvorrichtung (1) als das RF-Mesh-Gateway (131), das PLC-Gateway (132) und/oder der Peer (133) konfiguriert ist, um die Uplink-Verbindung (102) zu einem HES (101) des AMI-Systems (100) aufzubauen.

11. Verfahren zum Betreiben eines Advanced Metering Infrastructure(AMI)-Systems (100), umfassend Messvorrichtungen (1) nach einem der Ansprüche 1 bis 6, die für eine Mesh-Knoten-Kommunikation miteinander konfiguriert sind, **dadurch gekennzeichnet, dass** durch Hinzufügen eines Kommunikationsmoduls (20) zu einer Messvorrichtung (1), wobei das Kommunikationsmodul (20) eine Zählerschnittstelle (206) zum Verbinden des Kommunikationsmoduls (20) mit einer der Messvorrichtungen (1) und eine Gateway-Einheit umfasst, die konfiguriert ist, um mit dem AMI-System (100) Messdaten zu kommunizieren, die über die Zählerschnittstelle (206) empfangen werden, die jeweilige Messvorrichtung (1) von einem einfachen Kommunikations-Mesh-Knoten, der für eine Kommunikation mit mindestens einer weiteren Messvorrichtung (1) konfiguriert ist, die als ein Mesh-Knoten fungiert, in ein Gateway (30) umgewandelt wird, das dafür konfiguriert ist, eine Uplink- und/oder Downlink-Verbindung (102) innerhalb des AMI-Systems (101) für mindestens einen Cluster (111, 112) aufzubauen, der aus der jeweiligen Messvorrichtung (1) und mindestens einer weiteren Messvorrichtung (1) besteht, die für eine Mesh-Knoten-Kommunikation miteinander konfiguriert sind.

12. Verfahren nach Anspruch 11, **dadurch gekennzeichnet, dass** als mindestens ein Schritt der Umwandlung, das Kommunikationsmodul (20) in die Messvorrichtung (1) eingesetzt wird.

13. Verfahren nach Anspruch 11 oder 12, **dadurch gekennzeichnet, dass** im Laufe der Umwandlung mindestens eines von zusätzlicher Firmware und Konfigurationsdaten, die es der Messvorrichtung (1) ermöglichen, als das Gateway (30) zu dienen, an die Messvorrichtung (1) über das Kommunikationsmodul (20) bereitgestellt wird.

## Revendications

1. Dispositif de mesure (1), plus particulièrement compteur électrique pour mesurer de l'énergie électrique dans un système d'infrastructure de comptage avancée AMI (100), comprenant une unité de communication (202) permettant une communication par maillage de noeuds entre le dispositif de mesure (1) et au moins un autre dispositif de mesure (1),
**caractérisé en ce que**
le dispositif de mesure (1) comprend une interface de module (203) configurée pour raccorder un module de communication (20) au dispositif de mesure (1) afin de permettre au dispositif de mesure d'établir une liaison montante et / ou descendante (102) au sein du système AMI (100), et de transmettre des données de mesure qu'il a lui-même acquises ou reçues de l'au moins un autre dispositif de mesure (1) vers un système de tête de réseau HES (101) du système AMI (100) de sorte qu'en ajoutant le module de communication (20) au dispositif de mesure (1), le dispositif de mesure (1) est transformé du simple noeud de maillage de communication, configuré pour une communication avec l'au moins un autre dispositif de mesure (1) agissant comme un noeud de maillage, en une passerelle (30) configurée pour établir la liaison montante et / ou descendante (102) au sein du système AMI (101) pour au moins un cluster (111, 112) constitué du dispositif de mesure (1) et de l'au moins un autre dispositif de mesure (1) configurés pour une communication entre noeuds maillés l'un avec l'autre.

2. Dispositif de mesure (1) selon la revendication 1, **caractérisé en ce que** le dispositif de mesure (1) est configuré pour communiquer avec l'au moins un autre dispositif de mesure (1) par des signaux radiofréquence RF et / ou une communication par courant porteur PLC.

3. Dispositif de mesure (1) selon la revendication 1 ou 2, **caractérisé en ce que** le dispositif de mesure (1) comprend des extensions de communication embarquées incluant au moins un parmi un M-Bus sans fil (140) et un M-Bus câblé (141).

4. Dispositif de mesure (1) selon au moins l'une des revendications 1 à 3, **caractérisé en ce que** le dispositif de mesure (1) comprend une interface de réseau domestique HAN (142) pour au moins un parmi un port série, un port DSMR conforme aux exigences néerlandaises en matière de compteurs intelligents, et un port E/S auxiliaire pour commander les relais et entrées de commande de charge.

5. Dispositif de mesure (1) selon au moins l'une des revendications 1 à 4, **caractérisé en ce que** le dispositif de mesure (1) comprend un commutateur de commande d'alimentation.

6. Dispositif de mesure (1) selon au moins l'une des revendications 1 à 5, **caractérisé en ce qu'**un emplacement de module (7) au sein d'un boîtier (2) du dispositif de mesure (1) contient l'interface de module et est adapté pour loger au moins partiellement le module de communication (20).

7. Système d'infrastructure de comptage avancée AMI (100) pour mesurer une consommation énergétique, plus particulièrement d'énergie électrique
**caractérisé par** un dispositif de mesure (1) selon au moins l'une des revendications 1 à 6 ci-dessus, et un module de communication (20) comprenant une interface de compteur (206) pour relier le module de communication (20) au dispositif de mesure (1) et une unité de passerelle configurée pour communiquer au sein du système AMI (100) des données de mesure reçues *via* l'interface de compteur (206).

8. Système AMI (100) selon la revendication 7, **caractérisé en ce que** le module de communication (20) permet au dispositif de mesure (1) de servir comme au moins une parmi une passerelle de maillage RF (131) et une passerelle PLC (132) au sein du système AMI (100).

9. Système AMI (100) selon au moins l'une des revendications 7 à 8, **caractérisé en ce que** le module de communication permet au dispositif de mesure (1) de servir d'un pair (133) pour établir une liaison P2P au sein du système AMI (100).

10. Système AMI (100) selon la revendication 8 ou 9, **caractérisé en ce que** comme la passerelle de maillage RF (131), la passerelle PLC (132), et / ou le pair (133), le dispositif de mesure (1) est configuré pour établir la liaison montante (102) vers un HES (101) du système AMI (100).

11. Procédé de fonctionnement d'un système d'infrastructure de comptage avancée AMI (100) comprenant des dispositifs de mesure (1) selon l'une quelconque des revendications 1 à 6, configurés pour une communication entre noeuds maillés les uns avec les autres, **caractérisé en ce qu'**en ajoutant un module de communication (20) à un dispositif de mesure (1), le module de communication (20) comprenant une interface de compteur (206) pour relier le module de communication (20) à l'un quelconque des dispositifs de mesure (1) et une unité de passerelle configurée pour communiquer avec le système AMI (100) des données de mesure reçues *via* l'interface de compteur (206), le dispositif de mesure respectif (1) est transformé du simple noeud de maillage de communication, configuré pour une communication avec au moins un autre dispositif de mesure (1) agissant comme un noeud de maillage, en une passerelle (30) configurée pour établir une liaison montante et / ou descendante (102) au sein du système AMI (101) pour au moins un cluster (111, 112) constitué du dispositif de mesure respectif (1) et d'eau moins un autre dispositif de mesure (1) configurés pour une communication entre noeuds maillés l'un avec l'autre.

12. Procédé selon la revendication 11, **caractérisé en ce que** comme au moins une étape de la transformation, le module de communication (20) est inséré dans le dispositif de mesure (1).

13. Procédé selon la revendication 11 ou 12, **caractérisé en ce qu'**au cours de la transformation, au moins un parmi un microprogramme supplémentaire et des données de configuration permettant au dispositif de mesure (1) de servir comme la passerelle (30) est fourni au dispositif de mesure (1) par le module de communication (20).
